Europäisches Patentamt

European Patent Office

Office européen des brevets

(19)

(11) Veröffentlichungsnummer: **0 166 111 B1**

# (12) EUROPÄISCHE PATENTSCHRIFT

(45) Veröffentlichungstag der Patentschrift:
01.03.89

(51) Int. Cl.⁴: **H 05 K 5/06, H 01 C 10/14**

(21) Anmeldenummer: **85105126.8**

(22) Anmeldetag: **26.04.85**

(54) **Elektronisches Steuergerät.**

(30) Priorität: **25.05.84 DE 3419539**

(43) Veröffentlichungstag der Anmeldung:
**02.01.86 Patentblatt 86/1**

(45) Bekanntmachung des Hinweises auf die Patenterteilung:
**01.03.89 Patentblatt 89/9**

(84) Benannte Vertragsstaaten:
**DE FR GB IT SE**

(56) Entgegenhaltungen:
**DE-A- 1 675 403**
**DE-A- 2 436 697**
**GB-A- 2 061 625**
**US-A- 3 373 395**

(73) Patentinhaber: **ROBERT BOSCH GMBH, Postfach 50,
D-7000 Stuttgart 1 (DE)**

(72) Erfinder: **Bentz, Willy, Alte Grosssachsenheimer
Strasse 3, D-7123 Sachsenheim (DE)**
Erfinder: **Jakob, Gert, Weissenseeweg 10,
D-7000 Stuttgart 50 (DE)**

## Beschreibung

### Stand der Technik

Die Erfindung geht von einem elektronischen Steuergerät nach der Gattung des Hauptanspruchs aus. Die bei solch einem Steuergerät nach der GB-A-2 061 625 verwendete Stellvorrichtung für ein Mitten-Potentiometer besteht zwar aus einem Formteil. Das Formteil ist jedoch von der Gehäuseinnenseite in eine Bohrung des Gehäuses eingesetzt, an der Gehäuseaußenseite verrastet und mit einem zusätzlichen Ring gegen Zurückdrücken des Formteils in das Gehäuseinnere während des Stellvorgangs gesichert. Außerdem ist das bekannte Formteil nur senkrecht zu seiner Längsachse toleranausgleichend auslenkbar. Dabei ist von Nachteil, daß die Montage der das Potentiometer tragenden Leiterplatte im Gehäuse und des im Gehäusedeckel angeordneten Formteils und hier besonders das Einführen des Stellabschnitts in den Schlitz des Mitten-Potentiometers schwierig ist und leicht zu Schäden am Potentiometer führen kann. Wendel-Potentiometer dagegen lassen sich mit der bekannten Stellvorrichtung nicht einstellen, weil deren Formteil dabei nicht in seiner Längsrichtung Toleranzen ausgleichen kann und somit mechanischer Druck in unerwünschter Weise das Potentiometer beeinflussen kann. Weiterhin ist eine Stellvorrichtung für ein Wendelpotentiometer bekannt. Sie besteht aus einem an der Innenseite des Gehäuses mittels eines zusätzlichen Teiles gehaltenen und von außerhalb des Gehäuses bedienbaren Stellbolzen, an dem ein Ende einer im Gehäuse untergebrachten wellenförmigen Blattfeder lösbar befestigt ist, deren anderes Ende an der Stellschraube des Potentiometers ebenfalls lösbar befestigt ist. Auch hier ist die umständliche Montage der mehrteiligen Stellvorrichtung von Nachteil. Darüber hinaus muß der Abstand zwischen Stellbolzen und Potentiometer hierzu sehr genau eingehalten werden, um weder die Feder zu überlasten noch das Potentiometer durch mechanische Belastung in unerwünschter Weise zu beeinflussen.

### Aufgabe, Lösung und Vorteile der Erfindung

Der Erfindung liegt die Aufgabe zugrunde, ein elektronisches Steuergerät zu schaffen, in dem ein Potentiometer angeordnet ist, das von einer von außerhalb des Gehäuses zu betätigenden Stellvorrichtung eingestellt werden kann. Dazu ist es erforderlich, eine geeignete Stellvorrichtung so auszubilden, daß sie bei einem fertig montierten Steuergerät automatisch am Stellteil des Potentiometers eingreifen kann unabhängig von Fertigungstoleranzen und vom Wärmeverhalten der verschiedenen Werkstoffe des Steuergeräts.

Zur Lösung der Aufgabe sind die im Kennzeichnen des Hauptanspruchs angegebenen Maßnahmen vorgesehen.

In besonders vorteilhafter Weise ist dazu das mit Haltevorrichtung, mit mindestens einem Kreuzgelenk und S-förmigem Abschnitt sowie mit der Einführhilfe versehene Formteil, das die Stellvorrichtung bildet, von außen abgedichtet in das Gehäuse eingesetzt und darin verrastet, während der toleranzausgleichende Abschnitt mit dem S-förmigen elastischen Abschnitt Toleranzen sowohl senkrecht zur als auch in Längsrichtung des Formteils ausgleichen kann, so daß die Stellvorrichtung sowohl an Wendel- als auch an Mittenabgriff-Potentiometern automatisch an deren Stellteil angreifen und zum Einstellen der Potentiometer verwendet werden kann. Das jeweilige Potentiometer bleibt dabei frei von Zug-, Druck- oder Stößbelastungen durch das Formteil, welche Belastungen die Funktion des Potentiometers in unerwünschter Weise beeinflussen könnten.

Gemäß einer vorteilhaften Weiterbildung der Erfindung besteht das Formteil aus zähelastischem Kunststoff.

### Zeichnung

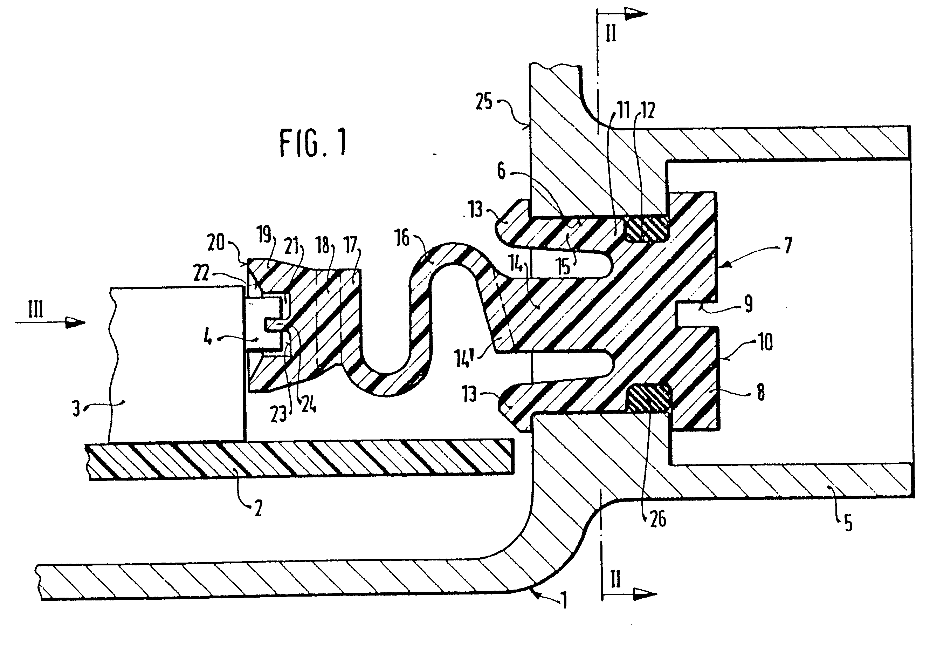

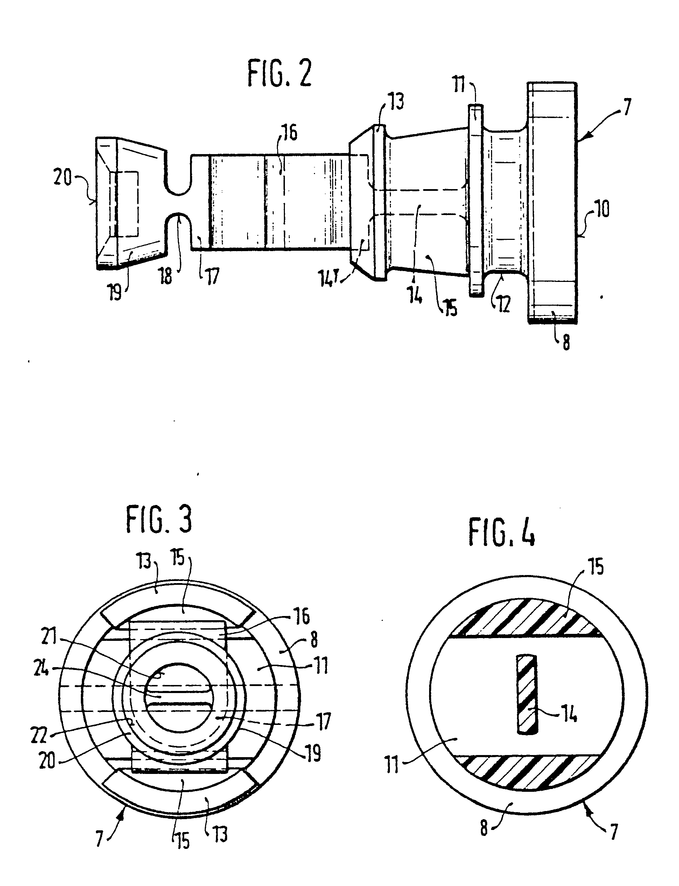

Ein Ausführungsbeispiel der Erfindung ist in der Zeichnung dargestellt und in der nachfolgenden Beschreibung näher erläutert. Es zeigen Figur 1 einen Teil eines elektronischen Steuergeräts im Längsschnitt durch das Formteil, Figur 2 eine Draufsicht und Figur 3 eine Ansicht des Formteils in Pfeilrichtung III in Figur 1 sowie Figur 4 einen Schnitt durch das Formteil entlang der Linie IV–IV in Figur 1.

### Beschreibung des Ausführungsbeispieles

Im Gehäuse 1 eines elektronischen Steuergeräts ist eine Leiterplatte 2 in an sich bekannter und nicht näher dargestellter Weise angeordnet. Die Leiterplatte 2 ist mit ebenfalls nicht dargestellten Leiterbahnen versehen. Die Leiterplatte 2 trägt elektronische Bauelemente, die mit den zugehörigen Leiterbahnen verbunden sind. Zu den Bauelementen gehört ein Potentiometer 3, beispielsweise ein Wendelpotentiometer mit einer Stellschraube 4.

Am Gehäuse 1 ist ein Auge 5 mit einer Bohrung 6 ausgebildet. In das vollständig montierte, feuchtigkeitsdicht abgeschlossene Steuergerät ragt ebenfalls feuchtigkeitsdicht durch die Bohrung 6 ein Formteil 7 als Stellvorrichtung an das Potentiometer 3. Das Formteil 7 ist aus zähelastischem Kunststoff geformt, beispielsweise Polyamid. Das Formteil 7 hat ein schraubenkopfförmiges Ende 8 mit einem Schlitz 9 an der Stirnseite 10. An das schraubenkopfförmige zylindrische Ende 8 schließt sich ein zylindrischer Dichtabschnitt 11 kleineren Durchmessers mit einer Ringnut 12 an. Der Dichtabschnitt 11 geht in zwei Rasthaken 13 und in einen schmalen Steg 14 über. Die Rasthaken 13 haben einen Schaft 15 mit kreisabschnittförmigem Querschnitt, der dem Durchmesser der Bohrung 6 angepaßt ist.

Der Steg 14 ist ein Teil eines ersten Kreuzgelenks, dessen senkrecht zu ihm angeformter anderer Teil 14' in ein S-förmiges Zwischenstück 16 übergeht. Das Ende 17 des Zwischenstücks 16 bildet einen Teil eines zweiten Kreuzgelenks, dessen anderer Teil als schmaler Steg 18 ausgebildet ist, der sich quer zum Ende 17 des Zwischenstücks 16 erstreckt.

An den Steg 18 schließt sich ein rotationskörperförmiger Stellabschnitt 19 an. Der Stellabschnitt 19 hat an seiner Stirnseite 20 eine sacklochartige Ausnehmung 21 mit einem trichterförmig erweiterten Randabschnitt 22. Am Boden 23 der Ausnehmung 21 ist eine Klinge 24 angeformt, die sich schraubenzieherartig in die Ausnehmung 21 erstreckt.

Das Formteil 7 dient als einteilige Stellvorrichtung für das Potentiometer 3, die von außen in das Gehäuse 1 eingesetzt und drehbar ist. In das voll-ständig montierte und feuchtigkeitsdicht geschlos-sene elektronische Steuergerät wird das Formteil 7 durch die Gehäusebohrung 6 eingeführt. Dabei werden die Rasthaken 13 auf den Steg 14 zugeschwenkt, bis das schraubenförmige Ende 8 des Formteils 7 soweit in die Bohrung 6 gedrückt ist, daß die Rasthaken 13 selbsttätig an die Innenwand 25 des Gehäuses 1 schnappen und das Formteil 7 am Gehäuse 1 verriegeln. In die Ringnut 12 des Formteils 7 ist ein Dichtring 26 eingesetzt, um das Formteil 7 feuchtigkeitsdicht in der Bohrung 6 zu halten.

Das Formteil 7 ist von außerhalb des Gehäuses 1 beispielsweise mit einem Schraubenzieher, der in den Schlitz gesteckt ist, in der Bohrung 6 drehbar. Dadurch gelingt es, den Stellabschnitt 19 des Formteils 7 so zu drehen, daß dessen Klinge 24 in den Schlitz der Stellschraube 4 des Potentiometers 3 greift. Das kann bereits beim Eindrücken des Formteils 7 in die Bohrung 6 geschehen. Durch weiteres Drehen des Formteils 7 wird dann das Potentiometer 3 eingestellt.

Durch Fertigungstoleranzen und unterschiedliche Ausdehnungskoeffizienten der verschiedenen Werkstoffe kann es geschehen, daß die Mittellinie der Bohrung 6 und somit des Formteils 7 nicht mit der Längsachse der Stellschraube des Potentiometers 3 fluchten oder auch der Abstand zwischen Potentiometer 3 und Gehäuseinnenwand 25 variiert. Mit Hilfe des trichterförmigen Randabschnittes 22 des Stellabschnitts 19, der wiederum über die Kreuzgelenke 17, 18 oder 14, 14' quer zu seiner Längsachse sowie durch das S-förmige federnde Zwischenstück 16 in Richtung seiner Längsachse toleranzausgleichend bewegbar ist, wird das Stellglied 19 über die Stellschraube 4 des Potentiometers 3 geschoben, so daß die Klinge 24 sicher in den Schlitz der Stellschraube 4 findet. Durch das über die Kreuzgelenke, und das S-förmige Zwischenstück 18, 17, 16, 14, 14' federnde Formteil 7 ist somit das Potentiometer frei von Drücken und Verspannungen sicher einstellbar. Auch läßt sich das federnde S-förmige Zwischenstück 16 entsprechend den aufzufangenden Drükken, die in Längsrichtung auf das Formteil 7 wirken, in seiner Stärke so anpassen, daß es nicht überlastet wird.

Zum Einstellen eines Potentiometers mit Mittenschlitz kann beispielsweise die Klinge am Stellabschnitt mit einer Einführhilfe versehen sein.

## Patentansprüche

1. Elektronisches Steuergerät mit einem feuchtigkeitsdicht verschlossenen Gehäuse (1), in dem eine Leiterbahnen und elektrische/elektronische Bauelemente sowie ein Potentiometer (3) tragende Leiterplatte (2) untergebracht ist, welches Potentiometer (3) mit einem von außerhalb des Gehäuses (1) betätigbaren, ebenfalls abgedichtet in das Gehäuse (1) ragenden Formteil (7) einstellbar ist, das mit einer am Gehäuse (1) verriegelbaren Haltevorrichtung aus mindestens zwei Rasthaken (13) und mit einem Toleranzen senkrecht zur Längsachse des Formteils (7) ausgleichenden Abschnitt (14, 14', 17, 18) mit mindestens einem Kreuzgelenk (14, 14') versehen ist und in einem am Potentiometer (3) angreifenden Stellabschnitt (24) endet, dadurch gekennzeichnet, daß das Formteil (7) von außen in eine Bohrung (6) des Gehäuses (1) eingesetzt und mit den Rasthaken (13) an der Gehäuseinnenwand (25) selbsttätig verriegelbar ist, der toleranzausgleichende Abschnitt (14, 14', 16 bis 18) ein zusätzlich Toleranzen in Längsrichtung des Formteils (7) ausgleichendes S-förmiges federndes Zwischenstück (16) hat und der Stellabschnitt (19, 24) eine Einführhilfe (22) aufweist.

2. Steuergerät nach Anspruch 1, dadurch gekennzeichnet, daß das Formteil (7) aus zähelastischem Kunststoff besteht.

## Claims

1. Electronic control unit having a moistureproof enclosed housing (1), in which a circuit board (2) carrying conductor tracks and electrical/ electronic components as well as a potentiometer (3) is accommodated, which potentiometer (3) can be adjusted by means of a shaped part (7) which projects, likewise sealed, into the housing (1) and which can be operated from outside the housing (1), which shaped part is provided with a securing device, which can be locked onto the housing (1), consisting of at least two latching hooks (13) and with a section (14, 14', 17, 18) with at least one universal joint (14, 14'), said section compensating tolerances vertical with respect to the longitudinal axis of the shaped part (7) and ending in an adjusting section (24) which engages on the potentiometer (3), characterized in that the shaped part (7) is inserted from the outside into a bore (6) of the housing (1) and can automatically be locked onto the housing inner wall (25) by means of the latching hooks (13), the tolerance-compensating section (14, 14', 16 to 18) has an S-shaped resilient intermediate piece (16) additionally compensating tolerances in the longitudinal direction of the shaped part (7), and the adjusting section (19, 24) has an insertion aid (22).

2. Control unit according to Claim 1, characterized in that the shaped part (7) is made of visco-plastic plastic.

## Revendications

1. Appareil de commande électronique comportant un boîtier (1) fermé de façon étanche vis-à-vis de l'humidité, dans lequel des pistes conductrices et des composants électriques/électroniques, ainsi qu'une plaquette de circuits imprimés (4) portant un potentiomètre (3) qui, à l'aide d'une pièce moulée (7) faisant saillie du boîtier (1) rendue de la même manière étanche vis-à-vis de l'humidité et réglable de l'extérieur de ce dernier, peut être réglé, cette pièce moulée (7) comprenant un dispositif de fixation verrouillable présentant au moins deux crochets d'arrêt (13) et une section (14, 14', 17, 18) composant des tolérances perpendiculairement à l'axe longitudinal de la pièce moulée (7), avec au moins un joint universel (14, 14') et se termine dans une section (24) s'engageant sur le potentiomètre (3), caractérisé en ce que la pièce moulée (7) est introduite de l'extérieur à travers un orifice (6) du boîtier (1) et peut se verrouiller automatiquement par les crochets d'arrêt (13) sur la paroi intérieure du boîtier (1) qui possède une pièce intermédiaire (16) faisant ressort, en forme de S compensant une tolérance additionnelle à la section compensatrice de tolérance (14, 14', 16 à 18) sur la longueur de la pièce moulée (7), et comporte un auxiliaire d'introduction (22) de la section de réglage (19, 24).

2. Appareil de commande, selon la revendication 1, caractérisé en ce que la pièce moulée (7) est en un matériau synthétique visco-élastique.

FIG. 1

EP 0 166 111 B1

# FIG. 2

# FIG. 3

# FIG. 4